(19) Europäisches Patentamt
European Patent Office
Office européen des brevets

(11) **EP 4 764 632 A1**

(12) **DEMANDE DE BREVET EUROPEEN**

(43) Date de publication:
**24.06.2026 Bulletin 2026/26**

(21) Numéro de dépôt: **25223659.1**

(22) Date de dépôt: **16.12.2025**

(51) Classification Internationale des Brevets (IPC):
***G02B 6/12*** *(2006.01)* ***G02B 6/122*** *(2006.01)*

(52) Classification Coopérative des Brevets (CPC):
**G02B 6/12004; G02B 6/12002; H01S 5/021; H01S 5/026; H01S 5/1032;** G02B 6/1228; G02B 2006/12061; G02B 2006/12078

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **20.12.2024 FR 2414853**

(71) Demandeur: **Commissariat à l'Energie Atomique et aux Energies Alternatives 75015 Paris (FR)**

(72) Inventeurs:
- **GUERBER, Sylvain**
  **38054 GRENOBLE Cedex 09 (FR)**
- **HASSAN, Karim**
  **38054 GRENOBLE Cedex 09 (FR)**
- **CHARBONNIER, Benoit**
  **38054 GRENOBLE Cedex 09 (FR)**
- **BRUEL, Guillaume**
  **38054 GRENOBLE Cedex 09 (FR)**

(74) Mandataire: **Hautier IP 20, rue de la Liberté 06000 Nice (FR)**

(54) **DISPOSITIF OPTOÉLECTRONIQUE COMPRENANT UNE STRUCTURE III-V SUR UN SUBSTRAT COMPRENANT UN GUIDE D'ONDE SILICIUM**

(57) L'invention concerne un dispositif optoélectronique (1) comprenant : un substrat (10) comprenant un guide d'onde (11) silicium, une structure III-V (12) formant un premier guide d'onde et comprenant : une première couche (13), par exemple dopée -n, une couche optiquement active (14), une deuxième couche (15) par exemple dopée -p, et une couche intermédiaire (16) à base d'un matériau III-V configurée pour former un guide d'onde d'indice de réfraction effectif compris entre l'indice de réfraction effectif du premier guide d'onde et l'indice de réfraction effectif du guide d'onde silicium (11), de façon à obtenir un couplage optique entre le premier guide d'onde (12) et le guide d'onde intermédiaire (16), et un couplage optique entre le guide d'onde intermédiaire (16) et le guide d'onde à base de silicium (11).

FIG. 4A

**Description**

**DOMAINE TECHNIQUE**

La présente invention concerne le domaine de l'optoélectronique, et plus particulièrement de l'optoélectronique sur substrat silicium. Elle trouve pour application particulièrement avantageuse l'intégration de structures hybrides III-V sur silicium avec un guide photonique silicium.

**ETAT DE LA TECHNIQUE**

Dans le domaine de l'optique intégrée sur silicium, les guides d'ondes sont des composants importants. Ils forment une circuiterie optique permettant d'interconnecter différents composants optoélectroniques. Les guides d'ondes sub-micrométriques sont notamment utilisés dans des applications liées aux télécommunications optiques, à la photonique, à l'optique non-linéaire et au calcul quantique.

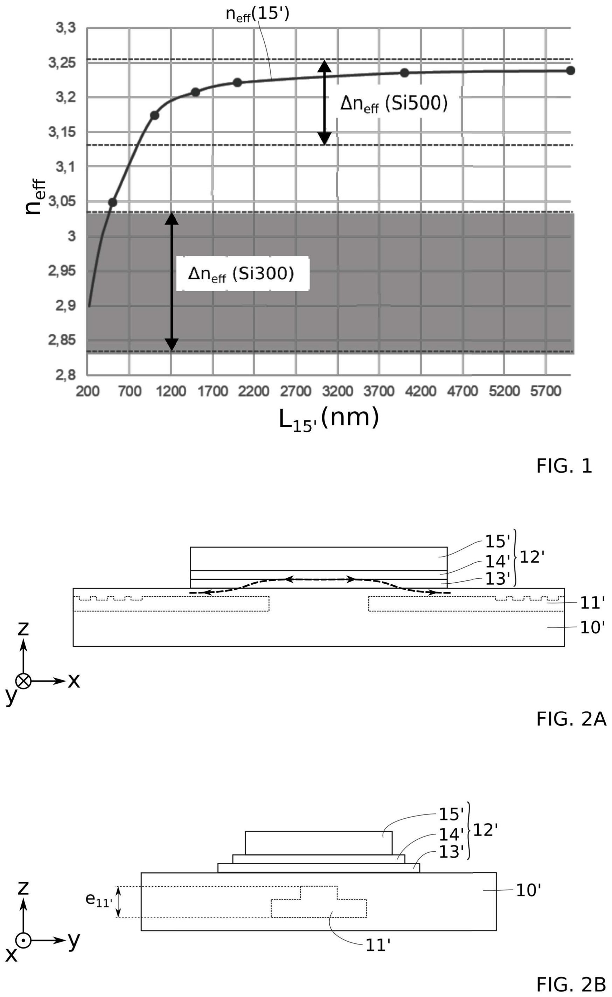

Il existe des dispositifs optoélectronique, par exemple illustrés en figure 2A et 2B, comprenant une structure optiquement active 12' à base de matériaux III-V et comprenant une première couche 13' (par exemple dopée N), une couche de puits quantiques, aussi appelée couche active 14', et une deuxième couche 15' (par exemple dopée P). La première couche 13', la couche de puits quantiques, aussi appelée couche active 14', et la deuxième couche 15' forment un premier guide d'onde 12', pouvant aussi être désigné comme guide d'onde actif. La structure optiquement active 12', aussi appelée structure III-V, est intégrée sur un substrat 10 comprenant un guide d'onde 11' à base de silicium. Ces dispositifs sont par exemple utilisés comme amplificateur, modulateur, ou bien à des fins de génération de lumière comme par exemple dans les lasers.

Typiquement, pour l'intégration de ces structures hybrides III-V sur silicium, on cherche à faire un couplage optique entre le guide d'onde actif et le guide d'onde 11' à base de silicium, par exemple enterré dans un substrat 10'. Le substrat 10' peut par exemple être un substrat SOI (de l'anglais *Silicon-On-Insulator,* traduit par silicium sur isolant).

Le couplage optique entre le guide d'onde actif et le guide d'onde à base de silicium 11' est limité par la différence d'indice de réfraction effectif entre le guide d'onde actif et le guide d'onde à base de silicium 11'. La figure 1 illustre à titre d'exemple l'indice de réfraction effectif :

- $n_{eff(15')}$ du guide actif 12' en fonction de la largeur de la couche 15' de p-InP (aussi appelé « barreau » InP) en nm,

- $\Delta n_{eff(Si500)}$) d'un guide d'onde 11' dit « épais » à base de silicium présentant un cœur d'épaisseur $e_{11}$' 500 nm et deux arêtes latérales de 300 nm d'épaisseur,

- $\Delta n_{eff(Si300)}$ d'un guide d'onde plus standard en photonique, à base de silicium présentant un cœur d'épaisseur 300 nm et deux arêtes latérales de 150 nm.

La figure 1 montre une inadéquation entre les indices de réfraction effectifs d'un barreau d'InP pour une largeur supérieure à 500 nm et un guide d'onde à base de silicium de cœur 300 nm standard en photonique. La transition entre la couche de puits quantiques de la structure optiquement active d'InP et le guide d'onde à base de silicium reste possible mais pour une largeur de barreau InP typiquement inférieure à 200 nm. Le barreau d'InP doit donc être très étroit. Cela impose de trop fortes contraintes de fabrication qui empêchent la production à l'échelle industrielle de ces dispositifs.

Pour contourner ce problème, il existe des solutions dans lesquelles une structure III-V est intégrée sur un guide épais à base de silicium. Le document Duan, G. H., et al. (2014). Hybrid III--V on Silicon Lasers for Photonic Integrated Circuits on Silicon. IEEE Journal of selected topics in quantum electronics, 20(4), 158-120, décrit un laser InP sur substrat SOI, avec un guide d'onde de silicium dit « épais » et présentant une épaisseur de 440 nm. La figure 1 montre en effet une bonne adéquation entre les indices de réfraction effectifs d'un barreau d'InP pour une largeur supérieure à 750 nm et un guide d'onde à base de silicium épais. L'utilisation d'un guide d'onde épais à base de silicium présente toutefois des inconvénients. Ce type de guide d'onde n'est en effet pas un standard en photonique et l'intégration de structure III-V sur ce type de guide d'onde demande à revoir et modifier la partie silicium des procédés de fabrication. Cela complexifie donc la fabrication de structures III-V intégrées sur guide d'onde à base de silicium.

Le document US 2024/061176 A1 décrit une structure comprenant un premier guide d'onde en silicium, sur lequel sont formés respectivement par dépôt un deuxième guide d'onde 26 diélectrique en SiN, AlN ou SiON et par report une structure III-V 40. Le couplage optique reste toutefois limité dans cette structure. Le deuxième guide d'onde ne permet en effet pas de pallier de façon satisfaisante la différence d'indice de réfraction effectif entre le guide d'onde actif et le guide d'onde à base de silicium. L'intégration sur silicium de la structure est complexe.

Le document US2022/255297 A1 divulgue un dispositif comprenant un substrat en silicium, un guide d'onde 24 SiN, un guide d'onde 14 de SiON couplé latéralement à un empilement multicouche III-V, l'empilement étant formé par épitaxie directe sur silicium. Les performances de couplage optiques restent peu satisfaisantes, du fait notamment de défauts aux interfaces et dans l'empilement.

Un objet de la présente invention est donc de proposer une solution facilitant l'intégration d'une structure optiquement active III-V hybride sur silicium, et notamment de sorte que l'intégration de la structure III-V soit plus compatible avec les contraintes de fabrication industrielle.

Les autres objets, caractéristiques et avantages de la présente invention apparaîtront à l'examen de la description suivante et des dessins d'accompagnement. Il est entendu que d'autres avantages peuvent être incorporés.

## RESUME

Pour atteindre cet objectif, selon un premier aspect on prévoit un dispositif optoélectronique comprenant :

- un substrat comprenant un guide d'onde à base de silicium présentant un indice de réfraction effectif,

- une structure optiquement active à base d'au moins un matériau III-V, dite « structure III-V », disposée sur le substrat, la structure III-V comprenant :

  ◦ une première couche présentant une première conductivité d'un premier type de porteur de charge,
  ◦ une couche active configurée pour émettre ou recevoir un rayonnement lumineux, et surmontant la première couche, et
  ◦ une deuxième couche présentant un deuxième type de porteurs de charge, et surmontant la couche active, la première couche, la couche active et la deuxième couche étant configurées ensemble pour former un premier guide d'onde, dit « guide d'onde actif » présentant un indice de réfraction effectif.

Avantageusement, la structure III-V comprend en outre une couche intermédiaire à base d'un matériau III-V configurée pour former un guide d'onde intermédiaire d'indice de réfraction effectif compris entre l'indice de réfraction effectif du premier guide d'onde et l'indice de réfraction effectif du guide d'onde à base de silicium, la couche intermédiaire étant disposée entre la couche active et le guide d'onde à base de silicium, de façon à obtenir un couplage optique entre le premier guide d'onde et le guide d'onde intermédiaire, et un couplage optique entre le guide d'onde intermédiaire et le guide d'onde à base de silicium.

La couche intermédiaire sert ainsi de guide d'onde intermédiaire entre le guide d'onde actif et le guide d'onde à base de silicium. Le guide d'onde intermédiaire présente ainsi un indice de réfraction effectif intermédiaire afin de combler l'écart d'indice effectif entre le guide d'onde actif et le guide d'onde à base de silicium.

La contrainte de largeur de la deuxième couche est donc relâchée. En outre, grâce à ce couplage optique intermédiaire, il est possible d'augmenter l'épaisseur de la première couche. Il est donc possible de dimensionner la structure III-V de façon plus compatible avec une fabrication industrielle.

En outre, cela permet d'intégrer la structure III-V sur un substrat comprenant un guide d'onde à base de silicium et de dimensions plus standard pour les applications photoniques. Typiquement, le guide d'onde peut être à base de silicium et présenter un cœur d'épaisseur 300 nm. Cela facilite donc l'intégration de la structure III-V en minimisant, et de préférence en évitant, les adaptations des procédés de fabrication du substrat.

Les solutions existantes mettent en œuvre une couche intermédiaire de matériau diélectrique ou semiconducteur formée par dépôt (parmi $Si_xN_y$, AlN, SiON, a-Si, p-Si, $Al_2O_3$, polymères, par exemple) sur le substrat comprenant le guide d'onde à base de silicium, ce qui ne permet pas d'obtenir un indice de réfraction effectif de la couche intermédiaire compris entre l'indice de réfraction effectif du premier guide d'onde et l'indice de réfraction effectif du guide d'onde à base de silicium. Il n'y a pas non plus de matériau III-V permettant d'obtenir un indice de réfraction effectif intermédiaire qui soit intégrable par une technique de dépôt, par exemple par épitaxie, sur le substrat Si sans occasionner des défauts dommageables au couplage optique.

Du fait du report de la structure III-V, il est possible d'utiliser un matériau provenant directement de la structure III-V pour la couche intermédiaire permettant d'obtenir un indice de réfraction effectif compris entre l'indice de réfraction effectif du premier guide d'onde et l'indice de réfraction effectif du guide d'onde à base de silicium. Le report permet en outre de s'affranchir de contraintes en température vis-à-vis du substrat comprenant le guide d'onde à base de silicium.

Un deuxième aspect concerne un procédé de fabrication d'un dispositif optoélectronique selon le premier aspect, le procédé comprenant :

- une fourniture de la structure III-V,

- une intégration par report de la structure III-V sur le substrat comprenant le guide d'onde à base de silicium.

## BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La figure 1 représente la variation de l'indice de réfraction effectif pour des éléments d'un dispositif optoélectronique selon l'art antérieur.
Les figures 2A et 2B représentent une vue en coupe respectivement longitudinale et transverse d'un dispositif optoélectronique selon l'art antérieur.
La figure 3 représente la variation de l'indice de réfraction effectif pour des éléments d'un dispositif optoélectronique selon un exemple de réalisation de l'invention.

Les figures 4A et 4B représentent une vue en coupe respectivement longitudinale et une vue du dessus d'un dispositif optoélectronique selon un exemple de réalisation de l'invention.

Les figures 5A et 5B sont des diagrammes respectivement de l'énergie de gap en contraint de la contrainte S, et de l'indice de réfraction en fonction de l'énergie de gap, dans une couche d'InGaAsP.

La figure 6 représente une vue en coupe transverse du dispositif optoélectronique illustré en figures 4A et 4B.

La figure 7 représente une vue du dessus des zones de transitions optiques du dispositif optoélectronique illustré en figures 4A et 4B, ainsi que la répartition du mode optique obtenu par simulation du dispositif correspondant, selon plusieurs plans en coupe transversale.

La figure 8 représente une vue en coupe longitudinale des zones de transitions optiques du dispositif optoélectronique illustré en figures 4A et 4B.

Les figures 9A et 9B représentent la répartition du mode optique obtenu par simulation du dispositif optoélectronique selon l'exemple de la figure 8, selon un plan de coupe longitudinal, et pour deux largeurs de barreau p-InP.

La figure 10 représente le facteur de confinement CF du mode optique dans la couche active comprenant les puits quantiques MQW (pour *multi quantum wells*) et dans une couche intermédiaire d'InGaAsP, en fonction de l'épaisseur de la couche intermédiaire et selon un exemple de réalisation du dispositif.

Les figures 11A et 11B représentent la répartition du mode optique obtenu par simulation du dispositif optoélectronique selon l'exemple de la figure 10 selon un plan de coupe transverse, et pour deux épaisseurs de la couche intermédiaire.

Les figures 12A et 12B représentent le pourcentage de transmission par couplage optique dans respectivement les première et deuxième zones de transition optique, en fonction de la longueur des zones de transition, selon un exemple.

Les figures 13A à 13C représentent des graphiques d'optimisation de paramètres géométriques du dispositif optoélectronique, selon un exemple.

Les figures 14A à 14C représentent des vues respectivement du dessus, en coupe transversale et en coupe longitudinale du dispositif selon un autre exemple de réalisation.

Les figures 15A à 15D représentent des vues en coupes longitudinales d'étapes du procédé de fabrication du dispositif optoélectronique, selon un exemple.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions relatives des couches, portions, structure, substrat ou autres éléments du dispositif ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, la deuxième couche s'étend dans un plan d'extension principale et présente au moins une dimension dans ledit plan supérieure ou égale à 500 nm, de préférence supérieure ou égale à 700 nm, et de préférence à 1 $\mu$m. Selon un exemple, la deuxième couche s'étend dans un plan d'extension principale et présente au moins une dimension dans ledit plan inférieure ou égale à 4 $\mu$m. Plus préférentiellement, cette dimension est sensiblement égale à 2 $\mu$m. Ainsi, la largeur de la deuxième couche, ou de façon équivalente du barreau III-V, peut être compatible avec les procédés de fabrication à l'échelle industrielle. Cela facilite notamment le report de la structure III-V sur le substrat.

Selon un exemple, l'indice de réfraction effectif du guide d'onde intermédiaire est strictement inférieur à l'indice de réfraction effectif du premier guide d'onde en dehors de la première zone de transition. Selon un exemple, l'indice de réfraction effectif du guide d'onde intermédiaire est strictement supérieur à l'indice de réfraction effectif du guide d'onde à base de silicium en dehors de la deuxième zone de transition.

Selon un exemple, la couche intermédiaire est à base, ou constituée, d'un matériau présentant un indice de réfraction compris entre 3,2 et 3,5. Lors du développement de l'invention, il a été mis en évidence que cette gamme d'indice de réfraction limite l'absorption de la lumière par la couche intermédiaire, tout en permettant le couplage intermédiaire du guide d'onde actif vers le guide d'onde à base de silicium.

Selon un exemple, la couche intermédiaire présente une épaisseur $e_{16}$ supérieure ou égale à 100 nm. Avec une épaisseur supérieure à 100 nm, l'épaisseur de la couche intermédiaire est suffisante pour effectuer le couplage optique intermédiaire et est reproductible avec les techniques standards de croissance de couche.

Selon un exemple, la couche intermédiaire présente une épaisseur $e_{16}$ inférieure ou égale à 250 nm. Une épaisseur inférieure à 250 nm permet une concentration de la lumière dans la couche active comprenant les puits quantiques, plutôt que dans la couche intermédiaire.

Selon un exemple, la couche intermédiaire est à base, ou constituée, d'InGaAsP. Lors du développement de l'invention, il a été mis en évidence que ce matériau limite l'absorption de rayonnement, notamment dans le domaine de l'infrarouge.

Selon un exemple, la couche intermédiaire est à base, ou constituée, d'InGaAlAs et/ou d'InGaAs, et/ou d'InGaAsP. Ces matériaux limitent l'absorption de rayonnement, notamment dans le domaine de l'infrarouge.

L'InGaAsP, l'InGaAlAs et l'InGaAs présentent en outre un accord de maille satisfaisant avec le matériau III-V de la couche active. Cela minimise les défauts à leur interface.

Selon un exemple, la première couche, la couche active et la deuxième couche sont à base ou constituée d'InP.

Selon un exemple, l'InGaAsP est de formule $In_{1-x}Ga_xAs_yP_{1-y}$ avec x compris entre 0,1 et 0,4, de préférence sensiblement égal à 0,4, et y compris entre 0,1 et 0,8, de préférence sensiblement égal à 0,8 Cette composition permet de maximiser l'indice de réfraction de la couche intermédiaire tout en limitant son absorption, notamment dans le domaine de l'infrarouge, pour une couche non contrainte. Ce matériau est donc particulièrement adapté pour améliorer le couplage par le guide d'onde intermédiaire.

Selon un exemple, la première couche comprend une première sous-couche et une deuxième sous-couche surmontant la première sous-couche, la couche intermédiaire étant intercalée entre les première et deuxième sous-couches. La couche intermédiaire est ici disposée au sein de la première couche, entre les première et deuxième sous-couches. Cette disposition permet de mieux répartir la distance entre la couche active, la couche intermédiaire et le guide d'onde à base de silicium, pour améliorer les couplages optiques. La fabrication du dispositif est simplifiée en limitant l'adaptation des procédés existants. On garde notamment un report de la structure III-V sur le substrat par l'intermédiaire de la première couche, comme à l'usuel, et non par l'intermédiaire d'une couche intermédiaire pouvant être à base d'un autre matériau.

Selon un exemple alternatif lequel la couche intermédiaire est disposée à l'interface entre la première couche et le substrat.

Selon un exemple, lequel la couche intermédiaire est disposée entre la couche active et le substrat.

Selon un exemple, la première sous-couche présente une épaisseur $e_{130}$ la deuxième sous-couche présente une épaisseur $e_{131}$, $e_{131}$ étant strictement supérieure à $e_{130}$. Ainsi, la couche intermédiaire est décentrée par rapport à la première couche. Il a été mis en évidence que cela limite les pertes de lumière par rapport à une configuration centrée (où $e_{131}$ est sensiblement égale à $e_{130}$) pour une même épaisseur de la première couche.

Selon un exemple, entre une première interface entre la couche active et la première couche et une deuxième interface entre la première couche et le substrat, la première couche présente une épaisseur $e_{13}$ comprise entre 500 nm et 1500 nm, et de préférence sensiblement égale à 1 $\mu m$. Cette épaisseur joue notamment sur la distance entre la couche active, la couche intermédiaire et le guide d'onde à base de silicium. Cette épaisseur permet un bon couplage optique entre le guide d'onde actif, le guide d'onde intermédiaire et le guide d'onde à base de silicium, tout en limitant les pertes de lumière. En outre, cette épaisseur améliore la dissipation thermique et diminue la résistance d'accès de la structure optiquement active. Cette épaisseur facilite la fabrication de la structure III-V, en relâchant notamment les contraintes sur les paramètres de gravure de l'empilement initial.

Selon un exemple, une première portion de la couche intermédiaire est au moins en partie superposée avec une portion de la couche active au niveau d'une première zone de transition optique, la première portion de la couche intermédiaire et la portion de la couche active présentant chacune une largeur $L_{16}$, $L_{14}$, dans leur plan d'extension principale, décroissante le long de la première zone de transition optique, selon une direction de couplage parallèle ou confondue avec la direction d'extension principale du guide d'onde à base de silicium en s'éloignant de la structure III-V, la première zone de transition optique présentant une longueur L1 supérieure ou égale à 100 $\mu m$ selon la direction de couplage.

Selon un exemple, une deuxième portion de la couche intermédiaire est au moins en partie superposée avec une portion du guide d'onde à base de silicium au niveau d'une deuxième zone de transition optique, la deuxième portion de la couche intermédiaire et la portion du guide d'onde à base de silicium présentant chacune une largeur $L_{16}$, $L_{11}$, dans leur plan d'extension principale, de sorte que :

- la largeur $L_{16}$ de la deuxième portion de la couche intermédiaire est décroissante, et

- la largeur $L_{11}$ de la portion du guide d'onde à base de silicium est croissante, le long de la deuxième zone de transition optique en s'éloignant de la structure III-V selon la direction de couplage, la deuxième zone de transition optique présentant une longueur L2 supérieure ou égale à 200 $\mu m$ selon la direction de couplage.

Dans le cadre de cette géométrie dite « en pointe », ces longueurs permettent une transmission, par couplages optiques successifs, supérieure à 99 % de la lumière.

Selon un exemple, le dispositif est un laser, un amplificateur optique ou un modulateur optique ou un photodétecteur.

Selon un exemple, le dispositif est configuré pour émettre ou recevoir un rayonnement dans le domaine lumineux de l'infra-rouge, et par exemple de longueur d'onde comprise entre 800 nm et 2 $\mu m$.

Selon un exemple, la première couche présente une conductivité de type « n », les porteurs de charge étant des électrons.

Selon un exemple, la deuxième couche présente une conductivité de type « p », les porteurs de charge étant des trous.

Selon un exemple, le procédé comprend un dimensionnement de la couche intermédiaire, le dimensionnement comprenant :

- une détermination d'une dimension $L_{15}$ de la deuxième couche dans son plan d'extension principale (x,y), ladite dimension étant supérieure ou égale à 500 nm, de préférence comprise entre 700 nm et 20 $\mu$m,

- la couche intermédiaire présentant une épaisseur $e_{16}$, une détermination de l'épaisseur $e_{16}$ en fonction de la dimension $L_{15}$ de la deuxième couche dans son plan d'extension principale,

et la fourniture de la structure III-V comprend :

- une croissance épitaxiale de la couche intermédiaire de sorte que la couche intermédiaire présente l'épaisseur $e_{16}$ déterminée.

- une gravure de la deuxième couche de sorte que la deuxième couche présente la dimension $L_{15}$ déterminée.

Notons que hors des zones de transitions ou de façon équivalente de couplage optique, le barreau III-V peut être beaucoup plus large, typiquement le barreau III-V peut présenter une largeur de quelques dizaines de $\mu$m.

Selon un exemple, le procédé comprend un dimensionnement de la première couche, le dimensionnement comprenant :

- une détermination d'une épaisseur $e_{13}$ de la première couche, prise entre une première interface entre la couche active et la première couche et une deuxième interface entre la première couche et le substrat, permettant le transfert d'au moins 90 % de la lumière entre le guide d'onde actif et le guide d'onde intermédiaire et entre le guide d'onde intermédiaire et le guide d'onde à base de silicium,

et dans lequel la fourniture de la structure III-V comprend :

- une croissance épitaxiale de la première couche de sorte que, après report, la couche active et le substrat soient séparés de l'épaisseur $e_{13}$ déterminée.

De manière parfaitement classique, une structure à base d'un matériau III-V est une structure comprenant, ou constituée de, un matériau comprenant au moins une espèce de la colonne III du tableau périodique et au moins une espèce de la colonne V de ce tableau.

De même, les abréviations suivantes relatives à un matériau M sont éventuellement utilisées :

- u-M, ou de façon équivalente i-M, réfère au matériau M intrinsèque ou non intentionnellement dopé, selon la terminologie habituellement utilisée dans le domaine de la microélectronique pour le préfixe u- ou de façon équivalente i-,
- n-M réfère au matériau M dopé N, N+ ou N++, selon la terminologie habituellement utilisée dans le domaine de la microélectronique pour le préfixe n-,
- p-M réfère au matériau M dopé P, P+ ou P++, selon la terminologie habituellement utilisée dans le domaine de la microélectronique pour le préfixe p-,

On entend par un substrat, un film, une couche « à base » d'un matériau M, un substrat, un film, une couche comprenant ce matériau M uniquement ou ce matériau M et éventuellement d'autres matériaux, par exemple des éléments d'alliage, des impuretés ou des éléments dopants. Le cas échéant, le matériau M peut présenter différentes stoechiométries.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Il est précisé que dans le cadre de la présente invention, l'épaisseur d'une couche ou du substrat se mesure selon une direction perpendiculaire à la surface selon laquelle cette couche ou ce substrat présente son extension maximale. L'épaisseur est ainsi prise selon une direction perpendiculaire aux faces principales du substrat sur lequel repose les différentes couches. Ainsi, une couche présente typiquement une épaisseur selon z, lorsqu'elle s'étend principalement le long d'un plan xy. Les termes relatifs « sur », « sous », « sous-jacent » se réfèrent préférentiellement à des positions prises selon la direction z.

Dans la suite, la longueur est prise selon la direction x, la largeur est prise selon la direction y, et la hauteur et la profondeur de gravure sont prises selon la direction z.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément. Par « en contact » ou « au contact de », on entend qu'une fine interface puisse exister, par exemple causée par la variabilité de fabrication.

Il est précisé que, dans le cadre de la présente invention, une troisième couche intercalée entre une première couche et une deuxième couche ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément, à moins qu'il n'en soit disposé autrement.

Par des couches, ou portions, ou zones « superposées » on entend ici que les couches, ou portions, ou zones sont en contact selon leur plan d'extension principale et disposées les unes au-dessus des autres selon la direction de l'empilement, cette direction étant perpendiculaire au plan d'extension principale.

Les valeurs dimensionnelles s'entendent aux tolérances de fabrication et de mesure près.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de $90 \pm 10°$ par rapport au plan.

Dans le cadre de l'invention, les énergies sont données en électronvolt, pour lequel $1\,eV \approx 1{,}602.10^{-19}\,J$, dans le système international des unités.

Pour les ondes lumineuses planes dans les milieux homogènes (par exemple dans les matériaux optiques), l'indice de réfraction n peut être utilisé pour quantifier l'augmentation du nombre d'onde (changement de phase par unité de longueur) causée par le milieu : le nombre d'onde est n fois plus élevé que dans le vide.

L'indice de réfraction effectif a une signification analogue pour la propagation de la lumière dans un guide d'onde à extension transversale restreinte : la valeur β (constante de phase) du guide d'onde (pour une certaine longueur d'onde) est l'indice de réfraction effectif multiplié par le nombre d'onde dans le vide, selon l'expression suivante :

$$\beta = n_{eff} \frac{2\pi}{\lambda}$$

L'expression "A et/ou B" signifie (A), (B), ou (A et B). L'expression "A, B et/ou C" signifie (A), (B), (C), (A et B), (A et C), (B et C), ou (A, B et C).

L'invention va maintenant être décrite en détail au travers de quelques exemples de réalisation non limitatifs. Le dispositif optoélectronique 1 selon l'invention peut par exemple être utilisé comme amplificateur, modulateur, à des fins de détection de lumière comme photodétecteur, ou bien à des fins de génération de lumière et par exemple pour un laser.

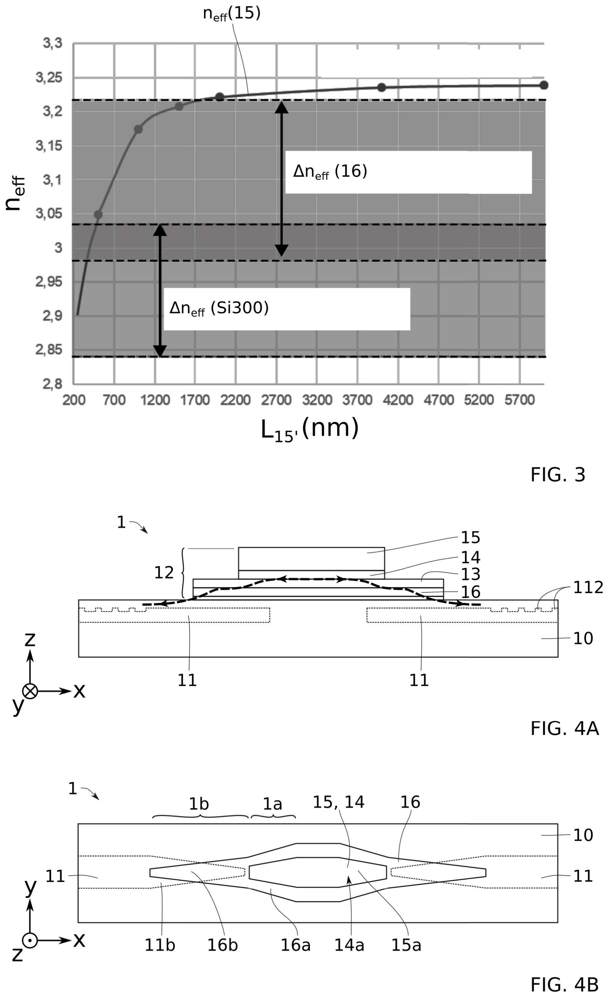

Les figures 3, 4A et 4B illustrent un exemple de dispositif optoélectronique selon l'invention.

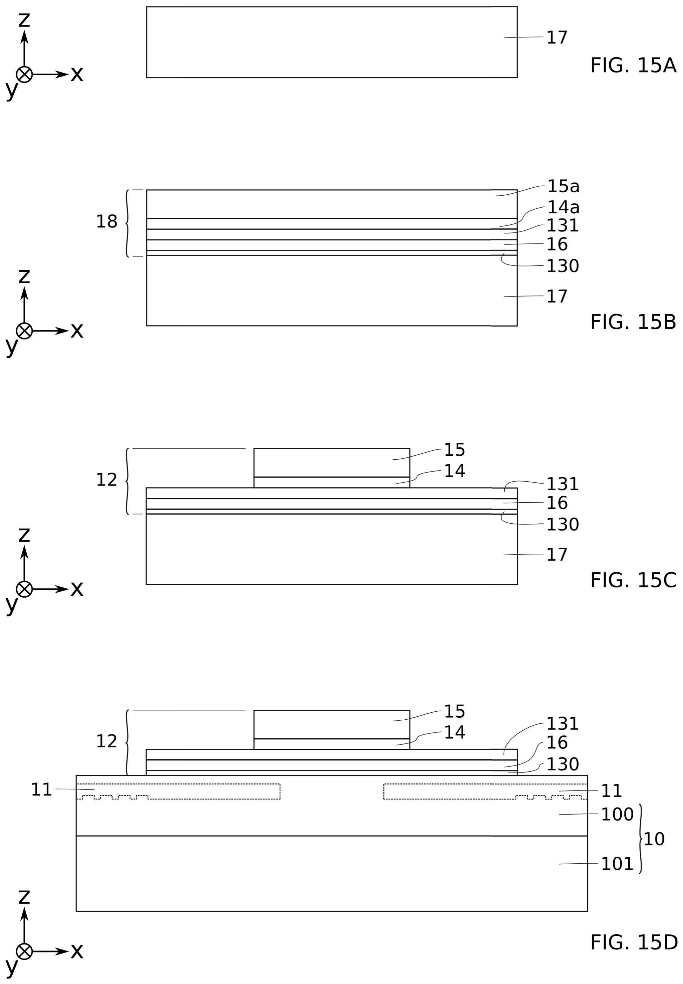

Le dispositif optoélectronique 1 comprend un substrat 10. Le substrat 10 peut par exemple être un substrat de type SOI. Le substrat 10 comprend un guide d'onde 11 à base, ou constitué, de silicium Si. Dans la suite ce guide d'onde est désigné par « guide d'onde Si 11 ». Le guide d'onde Si 11 peut être enterré dans une portion 100 à base, ou constitué, de $SiO_2$ du substrat 10 (comme illustré en figure 15D). De façon connue, le guide d'onde Si peut présenter des reliefs 112, et/ou au moins un filtre, et/ou un réseau de diffraction, et/ou des éléments de réflexion totale interne.

Le guide d'onde Si 11 s'étend typiquement de façon continue selon une direction x. Il guide alors la propagation du rayonnement lumineux selon x. Le guide d'onde Si 11 peut présenter, en section, différentes formes. Dans la suite, un guide d'onde en arête est décrit. Notons que d'autres géométries de guide d'onde, par exemple à fente ou à réseau périodique, sont possibles. Les modalités de dimensionnement décrites ensuite peuvent tout à fait s'adapter à d'autres géométries du guide d'onde. Dans les dessins d'accompagnement, seule une section du guide d'onde Si 11 dans les plans yz et xz est représentée. Cette section n'est toutefois pas nécessairement constante selon x, le long du guide d'onde Si 11.

Le dispositif optoélectronique 1 comprend en outre une structure optiquement active 12 à base, ou constituée de, au moins un matériau III-V. La structure III-V 12 comprend une première couche 13 présentant une première conductivité d'un premier type de porteurs de charges. Par exemple, la première couche est dopée « N », les porteurs de charges étant des électrons. La structure III-V 12 comprend une deuxième couche 15 présentant une deuxième conductivité d'un deuxième type de porteurs de charges. Par exemple, la deuxième couche est dopée « P », les porteurs de charge étant des trous. La structure III-V 12 comprend une couche active 14 configurée pour émettre ou recevoir un rayonnement lumineux. La couche active 14 comprend pour cela des puits quantiques. La couche active 14 peut aussi être désignée par l'acronyme MQW (de l'anglais « *multi quantum wells* »). La couche 14 est intercalée entre les première 13 et deuxième 15 couches. Les couches 13, 14, 15 forment un premier guide d'onde, pouvant être désigné par le terme guide d'onde actif. Dans la structure III-V, la deuxième couche 15 et la couche active 14 présentent généralement au moins une dimension dans le plan xy, et notamment la largeur $L_{15}$ selon la direction y, inférieure à la dimension correspondante de la première couche 13. La deuxième couche 15 et la couche active 14 peuvent ainsi former ce que l'on appelle un barreau III-V.

Selon un exemple, le dispositif optoélectronique 1 est configuré pour opérer dans le domaine de l'infrarouge. Par exemple, la longueur d'onde de travail du dispositif électronique 1 est sensiblement comprise entre 800 nm et 2 $\mu$m, et de préférence sensiblement égale à 1,55 $\mu$m.

Afin de pouvoir combler l'écart entre la plage d'indice de réfraction effectif $\Delta n_{eff(Si300)}$ d'un guide d'onde Si, et notamment d'épaisseur sensiblement égale à 300 nm selon les standards en photonique, et l'indice de réfraction effectif du barreau III-V $n_{eff(15)}$, le dispositif optoélectronique 1 comprend une couche intermédiaire 16 formant un guide d'onde intermédiaire permettant un couplage optique d'une part entre le guide d'onde actif et le guide d'onde intermédiaire 16, et d'autre part entre le guide d'onde intermédiaire 16 et le guide d'onde Si 11. Comme illustré en figure 3, le guide d'onde formé par la couche intermédiaire 16, aussi désigné par guide d'onde intermédiaire 16, peut présenter une gamme d'indice effectif dans une plage $\Delta n_{eff(16)}$ intermédiaire aux indices de réfraction effectifs du guide d'onde Si 11 et du barreau III-V. Cela permet de relâcher la contrainte en dimensionnement sur la largeur $L_{15}$ du barreau III-V.

Pour ces couplages optiques, la couche intermédiaire 16 est disposée entre la couche active 14 et le guide d'onde Si 11. Comme l'illustre la figure 4B, pour le couplage entre le guide d'onde intermédiaire 16 et le guide d'onde actif, une première portion 16a de la couche intermédiaire 16 peut être au moins en partie superposée selon la direction z, avec une portion 14a de la couche active 14. Cela forme une première zone de transition 1a. Pour le couplage entre le guide d'onde intermédiaire 16 et le guide d'onde Si 11, une deuxième portion 16b de la couche intermédiaire 16 et une portion 11b du guide d'onde Si 11 peuvent être au moins en partie superposées selon la direction z. Cela forme une deuxième zone de transition 1b.

Les couches de la structure III-V 12 sont au moins en partie superposées entre elles.

Selon un exemple, la structure III-V 12 est à base d'InP. Selon cet exemple, la première couche 13 est une couche à base ou constituée de n-InP et la deuxième couche 15 est une couche à base ou constituée de p-InP. La couche active 14 peut être une couche à base de i-InP. La couche active 14 peut être à base ou constituée d'au moins un alliage ternaire ou quaternaire comprenant de l'InP et d'un autre élément choisi parmi Ga, As, Al, et/ou P par exemple. La couche 14 peut par exemple être à base ou constituée d'InGaAsP ou d'InGaAsAl. La couche 14 peut être intrinsèque, et donc ne pas être dopée. Dans la suite, on considère à titre non limitatif que la structure III-V 12 est à base d'InP. Notons que d'autres matériaux III-V sont possibles. Notamment, les démarches de choix des matériaux et de dimensionnements décrits ci-dessous peuvent tout à fait s'appliquer à d'autres matériaux III-V.

Les matériaux de la couche intermédiaire 16 présente de préférence un accord de maille avec le matériau III-V de la structure III-V 12. Le matériau de la couche intermédiaire 16 présente de préférence une absorption limitée à la longueur d'onde de travail. La couche 16 peut être à base ou constituée d'au moins un alliage ternaire ou quaternaire comprenant de l'InGaAs et d'un autre élément choisi parmi Al, et/ou P par exemple. La couche 16 peut par exemple être à base ou constituée d'InGaAsP, d'InGaAlAs et/ ou d'InGaAs. Dans le cas de l'InP, le matériau InGaAsP est choisi car il présente une faible absorption à la longueur d'onde de travail de 1,55 $\mu$m (et notamment par rapport au matériau InGaAs par exemple).

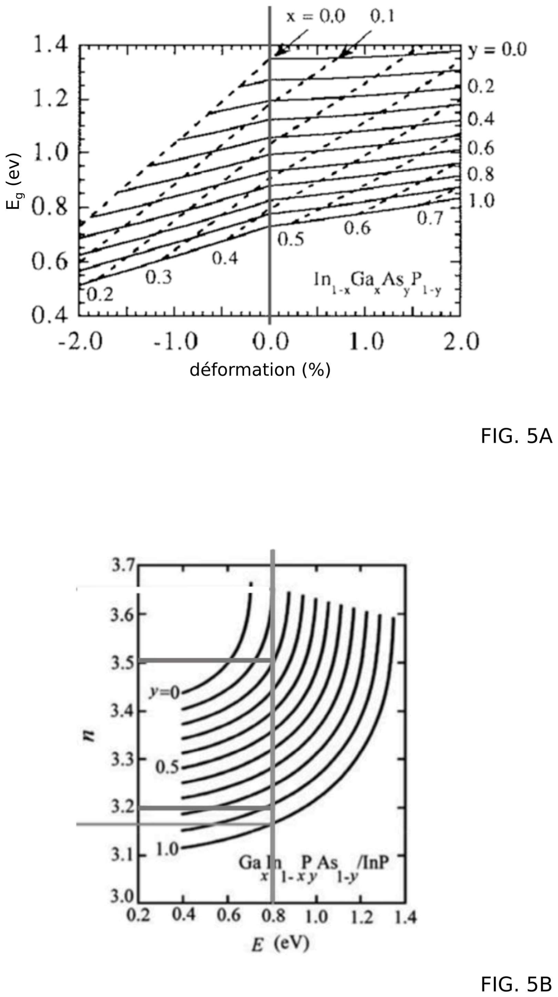

La composition en $In_{1-x}Ga_xAs_yP_{1-y}$ peut être choisie selon la démarche suivante. En utilisant les diagrammes illustrés en figures 5A (*Adachi - 2009 - Properties of Semiconductor Alloys Group-IV, 111-Vand II-VI semiconductors*) et 5B (*Minch Park - 1999 - Theory and experiment of InGaAsP and InGaAlAs long-wavelength strained*) on se place tout d'abord en abscisse 0% de la figure 5A afin d'avoir une couche intermédiaire 16 non contrainte. Pour une longueur d'onde de travail de 1,55 $\mu$m, l'énergie de gap $E_g$ correspondante est de préférence supérieure ou égale à 0,8 eV pour éviter l'absorption. D'après la figure 5A, l'intersection entre une $E_g = 0,8$ eV et la valeur de y pour une abscisse de 0% implique donc y inférieure ou égal à sensiblement 0,8. Avec la figure 5B, l'indice de réfraction n du matériau peut être déterminé selon la composition du matériau et l'énergie E du photon. En reportant cette valeur du y sur le graphique de la figure 5B (pour lequel les valeurs de y et 1-y sont inversées par rapport à la figure 5A), on obtient y supérieur ou égal à 0,2. Sur la figure 5B, l'intersection entre la ligne de composition y = 0,2 et E = 0,8 eV, et l'intersection entre la ligne de composition y = 1 et E = 0,8 eV donnent un indice de réfraction sensiblement compris entre sensiblement 3,17 et 3,5.

L'intersection entre l'abscisse de contrainte 0 % en figure 5A, et la ligne de composition y correspondante peut donner la valeur de x. Par exemple, pour y=0,8 on a x sensiblement égal à 0,4.

Selon la composition $In_{1-x}Ga_xAs_yP_{1-y}$ comme décrits en figure 5A, on a :

- x non nul et de préférence compris entre 0 et 0,4, et/ou

- y non nul et inférieur ou égal à 0,8, et de préférence compris entre 0,1 et 0,8.

Pour maximiser l'énergie de gap et limiter l'absorption de la lumière à la longueur d'onde de travail, il peut être préférable de limiter l'indice de réfraction du matériau. Si l'on vise une grande énergie de gap, on va par exemple minimiser l'indice de réfraction de l'InGaAsP (n tendrait par exemple vers 3,2). Or, utiliser un indice de réfraction faible implique d'épaissir la couche intermédiaire 16, ce qui peut rendre le couplage optique avec les autres guides plus difficile. L'optimisation du dimensionnement du dispositif peut dépendre des applications visées.

Pour conserver des épaisseurs de couche fine, un indice de réfraction élevée est préférable. Afin de trouver un compromis entre ces effets, la couche intermédiaire 16 présente de préférence un indice de réfraction sensiblement égal à 3,5. Cela favorise le couplage tout en gardant une épaisseur de la couche intermédiaire 16 raisonnable.

De préférence, la composition est $In_{0,6}Ga_{0,4}As_{0,8}P_{0,2}$ pour présenter un indice de réfraction sensiblement égal à 3,5.

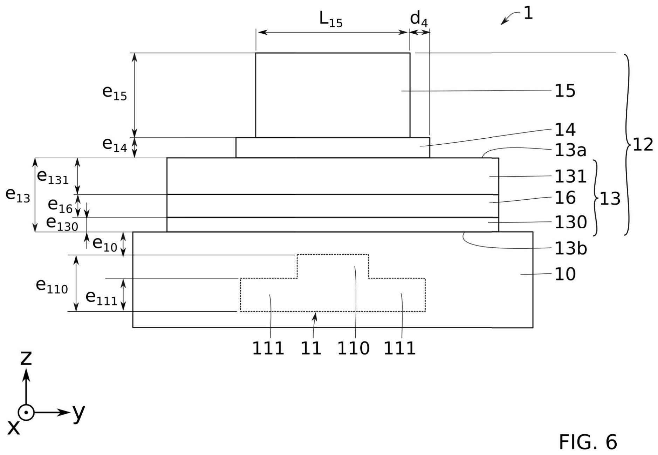

Des exemples particuliers de dimensionnement et de géométrie sont ensuite décrits en référence aux figures 6 à 13C.

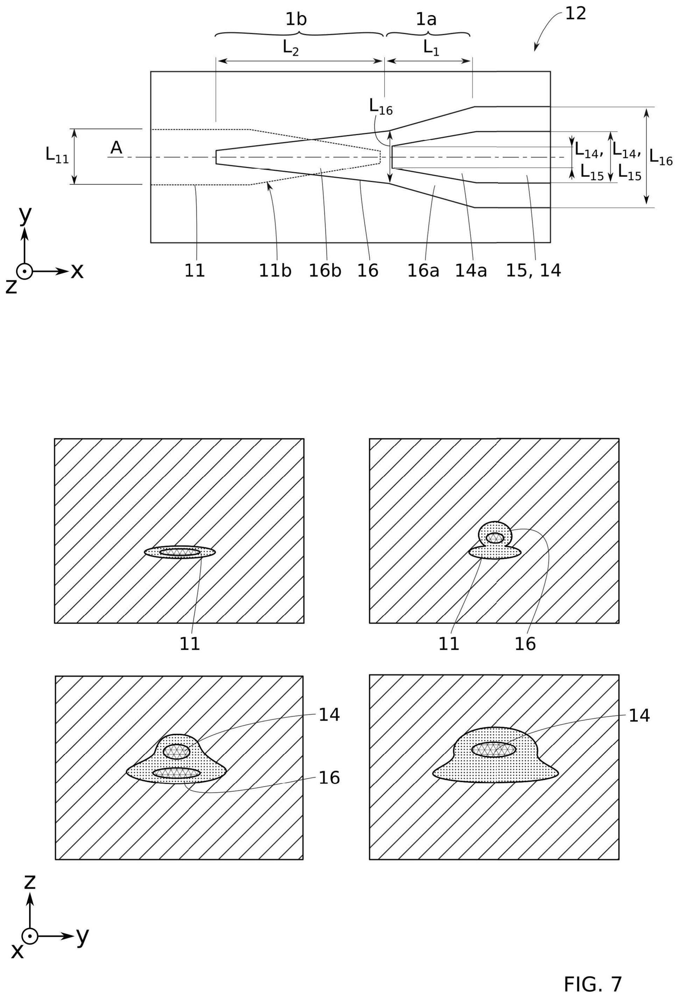

Selon un premier exemple illustré en figures 6 et 7, le dispositif 1 comprend le substrat 10 à base de $SiO_2$, dans lequel est enterré un guide d'onde Si 11. Le guide d'onde Si 11 présente une partie centrale 110 présentant une épaisseur sensiblement égale à 300 nm. La partie centrale 110 est encadrée selon la direction y par deux arêtes 111 présentant une épaisseur sensiblement égale à 150 nm. La partie centrale 110 peut être surmontée par une portion du substrat 10 présentant une épaisseur $e_{10}$ sensiblement égale à 100 nm.

La structure III-V 12 est disposée sur le substrat 10. Dans la structure III-V 12, la couche intermédiaire 16 est de préférence disposée au sein de la première couche 13. Ainsi, la première couche 13 comprend une première sous-couche 130 et une deuxième sous-couche 131, la couche intermédiaire 16 étant intercalée entre la première sous-couche 130 et la deuxième sous-couche 131.

Comme illustré en figure 7, pour faire le couplage optique au niveau des première 1a et deuxième 1b zones de transition, le dispositif optoélectronique 1 peut présenter une configuration dite « en pointe ». Dans une configuration en pointe, au moins une dimension dans le plan xy, et par exemple la largeur y, de la couche active 14, de la couche intermédiaire 16 et du guide d'onde Si 11, est croissante ou décroissante, de préférence strictement, sur chaque zone de transition 1a, 1b, selon une direction de couplage A et en s'éloignant de la structure III-V (sens -x sur la figure 7). La direction de couplage peut être parallèle, et de préférence confondue, avec la direction d'extension principale du guide d'onde Si 11. Dans la suite, on considère les notions de croissant ou décroissant selon la direction de couplage A et en s'éloignant de la structure III-V (sens - x sur la figure 7). Dans une configuration en pointe, au moins une dimension dans le plan xy, et par exemple la largeur y, de la couche active 14, de la couche intermédiaire 16 et du guide d'onde Si 11, est croissante ou décroissante, de préférence strictement, sur au moins 50 % et de préférence au moins 90 % et de préférence sur la totalité de chaque zone de transition 1a, 1b, selon une direction de couplage A et en s'éloignant de la structure III-V.

Plus particulièrement, au niveau de la première zone de transition 1a, la couche active 14, éventuellement la deuxième couche 15, présente une largeur $L_{15}$ décroissante de façon linéaire entre une première largeur et une deuxième largeur, par exemple de 2 μm à 500 nm. La couche intermédiaire 16 présente selon cet exemple une largeur $L_{16}$ décroissante de façon linéaire entre une première largeur et une deuxième largeur, par exemple entre 6 μm et 2 μm. De préférence la couche intermédiaire 16 et la couche active 14 sont centrées selon la direction de couplage A au moins au niveau de la première zone de transition 1a. La zone de variation de largeur de la couche active 14 et de la couche intermédiaire 16 peut s'étendre selon la direction x sur une longueur L1.

Selon un exemple, au niveau de la deuxième zone de transition 1b, la couche intermédiaire 16, présente une largeur $L_{16}$ décroissante de façon linéaire entre une première longueur et une deuxième longueur, par exemple de 2 μm à 500 nm. Selon un exemple, la décroissance de la largeur $L_{16}$ de la couche intermédiaire 16 est en continuité de la première zone transition 1a à la deuxième zone transition 1b. Le guide d'onde Si 11 peut présenter selon cet exemple une largeur $L_{11}$ croissante de façon linéaire entre une première largeur et une deuxième largeur, par exemple entre 500 nm et 2 μm. De préférence, la couche intermédiaire 16 et le guide d'onde Si 11 sont centrés selon la direction de couplage A au moins au niveau de la première zone de transition 1b. La zone de variation de largeur du guide d'onde Si 11 et de la couche intermédiaire 16 peut s'étendre selon la direction x sur une longueur L2.

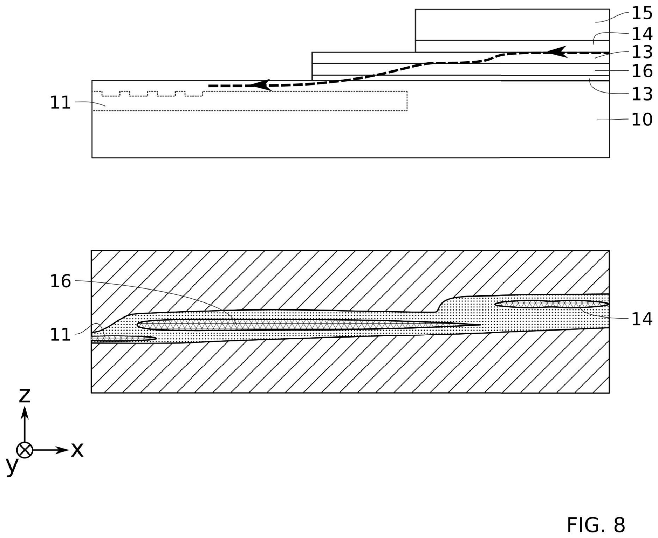

Comme illustré par les figures 7 et 8, le couplage optique entre le guide d'onde actif et le guide d'onde intermédiaire 16 puis entre le guide d'onde intermédiaire 16 et le guide d'onde Si 11, a été modélisé pour la géométrie illustrée dans les figures 6 et 7. Sur la figure 7, on peut voir plusieurs plans de coupe transverse dans le plan yz qui montre les passages successifs de la lumière depuis la couche active 14 jusqu'au guide d'onde Si 11. La figure 8 illustre ceci selon un plan de coupe longitudinal xz.

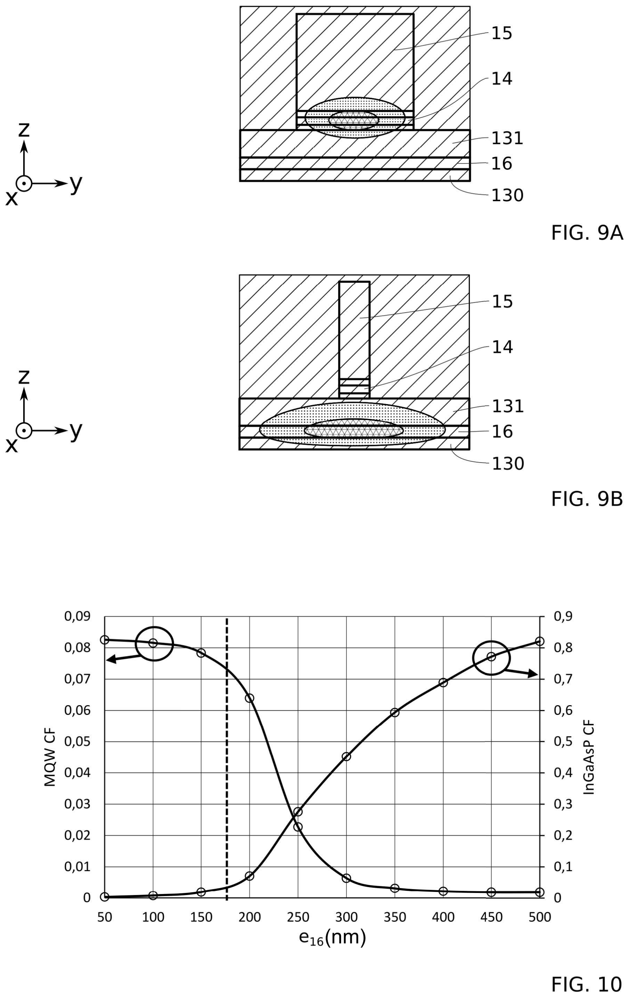

La deuxième couche 15 et la couche active 14 sont généralement gravées pour former le barreau III-V La deuxième couche 15 peut donc présenter une largeur $L_{15}$ prise selon la direction y. Les transitions optiques dans la couche active 14 sont typiquement gouvernées par la largeur $L_{15}$, comme l'illustrent les figures 9A et 9B pour respectivement $L_{15} = 4$ μm et $L_{15} = 0,5$ μm. Selon un exemple, afin de concentrer la lumière dans la couche active 14, la deuxième couche 15 présente une largeur $L_{15}$ supérieure à 500 nm, et de préférence comprise entre 2 μm et 4 μm. On considère ici la largeur $L_{15}$ au niveau le plus large du barreau III-V, hors zone de transition optique. La couche active 14 peut présenter la même largeur que celle de la deuxième couche 15. En alternative, comme illustré en figure 6, la couche active 14 peut présenter un débord, de préférence de part et d'autre de la deuxième couche 15. Ce débord peut s'étendre sur une distance $d_{14}$ prise selon la direction y, par exemple sensiblement égale à 200 nm.

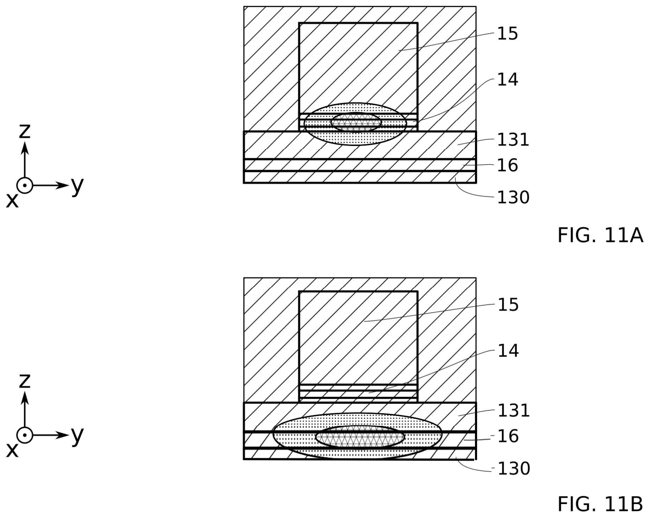

La largeur $L_{15}$ est interdépendante avec l'épaisseur $e_{16}$ de la couche intermédiaire 16. On souhaite concentrer la lumière dans la couche active 14. Comme illustré en figures 10 et 11A, en fonction de la largeur $L_{15}$ choisie, l'épaisseur maximale de la couche intermédiaire 16 peut être fixée. Pour une largeur $L_{15}$ de deuxième couche 15 p-InP sensiblement égale à 4 $\mu$m, et une couche intermédiaire 16 d'InGaAsP d'indice de réfraction n = 3,5 disposée à 200 nm de l'interface inférieure 13b entre le substrat 10 et la première sous-couche 130, on peut observer une prévalence de la lumière dans la couche intermédiaire 16 à partir d'une épaisseur $e_{16}$ supérieure à 250 nm (par exemple comme illustré en figure 11B pour une épaisseur $e_{16}$ de 350 nm). On choisit donc une épaisseur $e_{16}$ inférieure ou égale à 250 nm, et de préférence sensiblement égale à 175 nm, afin de concentrer la lumière dans la couche active 14. La figure 11A montre à titre d'exemple une prévalence de la lumière dans la couche active 14 pour une épaisseur $e_{16}$ de 100 nm).

Plus on souhaite diminuer l'épaisseur $e_{16}$ de la couche intermédiaire, plus son indice de réfraction effectif va baisser et donc plus il faudra diminuer la largeur $L_{15}$ de la deuxième couche 15. On comprend donc qu'un compromis peut être trouvé du fait de cette interdépendance.

Par ailleurs, la couche active 14 et la couche intermédiaire 16 sont de préférence suffisamment éloignées pour permettre un couplage optique maximal et minimiser les pertes de couplage. Cela peut permettre de limiter la largeur $L_{15}$ de la deuxième couche 15. Cela permet en outre de relâcher les contraintes sur l'étape de gravure du barreau III-V. En effet, une problématique souvent rencontrée et une sur-gravure du barreau III-V entraînant une gravure de la première couche 13. Avec une épaisseur plus importante de la première couche 13, une gravure de cette couche 13 aura un impact plus modéré notamment sur la résistance d'accès du dispositif optoélectronique. Pour cela, et en référence à la figure 6 par exemple, l'épaisseur totale $e_{13}$ de la première couche, prise entre une première interface 13a avec la couche active 14 et une deuxième interface 13b avec le substrat 10, peut être sensiblement égale à 1 $\mu$m.

La couche active 14 et le guide d'onde Si 11 peuvent être espacés d'une distance, prise selon la direction z sensiblement perpendiculaire au plan d'extension principale de la couche active 14, comprise entre 800 nm et 1200 nm, et de préférence sensiblement égale à 1100 nm.

En outre, il a été observé que les pertes de couplage étaient encore réduites en décalant vers le bas la couche intermédiaire 16 au sein de la première couche 13. Par exemple, le ratio d'épaisseur $e_{131}/e_{130}$ peut être compris entre 2,5 et 3,5. Selon un exemple,

l'épaisseur $e_{130}$ de la première sous-couche 130 est sensiblement égale à 200 nm. Ainsi, avec une épaisseur $e_{10}$ sensiblement égale à 100 nm, la distance entre la couche intermédiaire 16 et le guide d'onde Si 11 peut être sensiblement égale à 300 nm. Selon un exemple, l'épaisseur $e_{131}$ de la deuxième sous-couche 131 peut être sensiblement égale à 625 nm.

Selon un exemple, l'épaisseur $e_{14}$ de la couche active 14 peut être sensiblement comprise entre 200 nm et 500 nm. Selon un exemple, l'épaisseur $e_{15}$ de la deuxième couche active 15 peut être sensiblement comprise entre 1 $\mu$m et 3 $\mu$m.

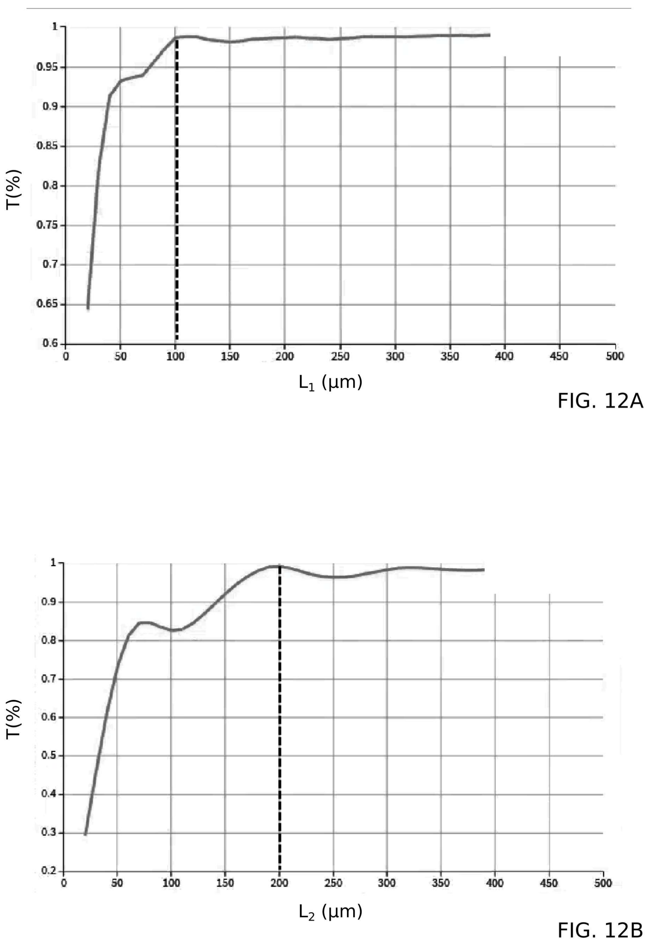

Par exemple et en référence aux figures 7, 12A et 12B, la longueur, prise selon x, des zones de transition optique 1a, 1b peut être adaptée pour maximiser la transmission de la lumière entre respectivement la couche active 14 et la couche intermédiaire 16, et la couche intermédiaire 16 et le guide d'onde Si 11. Par modélisation selon les caractéristiques géométriques précédemment présentées, il a été mis en évidence qu'une transmission au moins supérieure ou égale à 95 % et de préférence supérieure ou égale 99 % pouvaient être obtenue avec L1 supérieure ou égale à 100 $\mu$m et L2 supérieure ou égale à 200 $\mu$m.

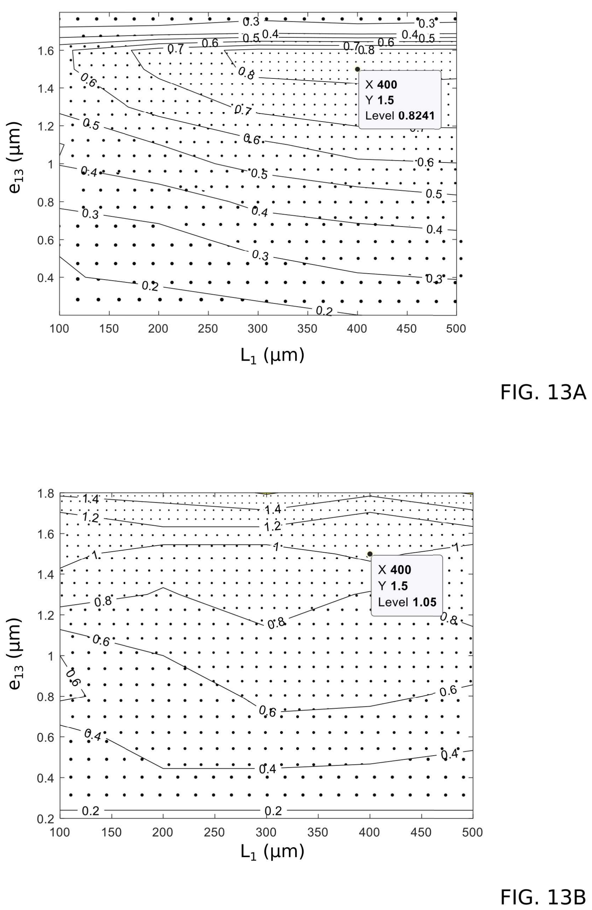

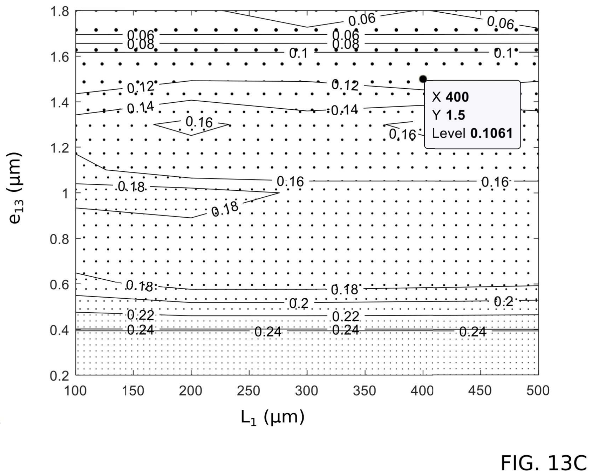

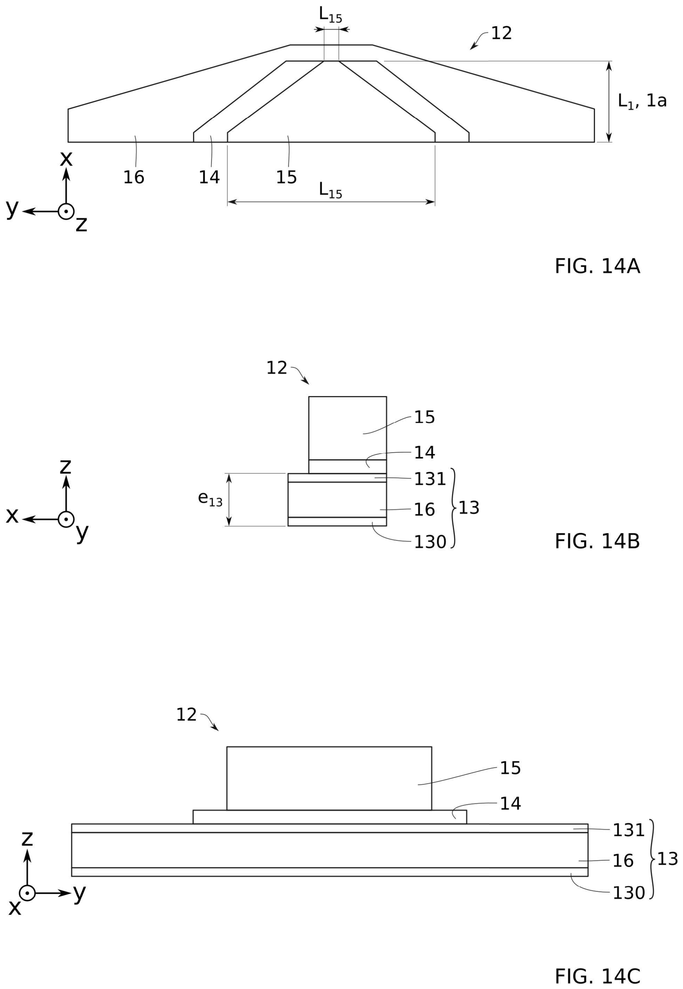

Comme il ressort de la description qui précède, les paramètres géométriques peuvent être déterminés pour optimiser la transmission de la lumière par couplages successifs dans le dispositif optoélectronique 1. Les interdépendances entre ces paramètres peuvent être étudiées par modélisation. Pour illustrer cela, les figures 13A à 13C montrent des optimisations de dimensionnement du dispositif 1. Les simulations présentées en figures 13A, 13B, 13C et les schémas associés (figures 14A, 14B, 14C) concernent la première transition entre le guide actif et le guide intermédiaire 16 (zone transition 1a en figure 7), selon un exemple. Par exemple, la figure 13A représente la transmission de la première transition 1a en fonction de l'épaisseur $e_{13}$ de la première couche 13 et de la longueur L1 de la première zone de transition 1a et ce pour une géométrie comprenant une plus petite largeur $L_{15}$ de la couche p-InP, au niveau de la zone entre les deux transitions d'une géométrie en pointe, sensiblement égale à 500 nm.

La figure 13A montre la valeur de transmission de la transition en fonction de la longueur de celle-ci (L1) et de l'épaisseur de n-InP ($e_{13}$) pour une valeur optimale d'InGaAsP qui peut être lue sur la figure 13B. Par exemple, pour la valeur présentée en encart (transmission de 82,41% pour une transition de 400 $\mu$m de long et une épaisseur $e_{13}$ de n-InP de 1,5 $\mu$m), l'épaisseur d'InGaAsP correspondante est de 1,05 $\mu$m.

La figure 13B montre l'épaisseur optimale de la couche intermédiaire d'InGaAsP (comprise entre $0,1.e_{13}$ et $0,9.e_{13}$) en fonction de l'épaisseur de n-InP ($e_{13}$) et de la longueur L1 de la transition. Par exemple, pour une transition de 400 $\mu$m de long et une épaisseur de n-InP de 1,5 $\mu$m, l'épaisseur optimale d'InGaAsP simulée est de 1,05 $\mu$m (encart dans la figure).

Par exemple, la figure 13C illustre le confinement obtenu en fonction de l'épaisseur $e_{13}$ de la première couche 13 et de la longueur L1 de la première zone de transition 1a, selon un exemple. Est représentée à la figure 13C la fraction du champ électrique recouvrant l'empilement des puits et de leurs barrières. On obtient notamment un recouvrement de 10,61 % pour une longueur $L_1$ de 400 $\mu$m et une épaisseur de n-InP $e_{13}$ de 1,5 $\mu$m (encart dans la figure). Comme les puits et leurs barrières ont des épaisseurs sensiblement identiques, le confinement du champ dans les seuls puits quantiques vaut environ la moitié de la valeur représentée, soit 5,3% dans ces conditions. C'est cette valeur qui intervient dans le calcul du gain du laser.

Bien d'autres géométries sont possibles en plus de celles décrites précédemment. À titre d'exemple les figures 14A à 14C décrivent un autre exemple de géométrie. Dans cette géométrie, la largeur $L_{15}$ de la deuxième couche est sensiblement égale à 6 $\mu$m. La pointe de la deuxième couche 15 présente une largeur $L_{15}$ sensiblement égale à 500 nm. La couche active 14 peut présenter un débord de part et d'autre de la deuxième couche 15 sur une distance $d_{14}$ sensiblement égale à 1 $\mu$m. La longueur L1 peut être comprise entre 100 $\mu$m et 500 $\mu$m. L'épaisseur totale $e_{13}$ de la première couche 13 peut être comprise entre 0,2 $\mu$m et 1,8 $\mu$m. La couche intermédiaire 16 peut présenter une épaisseur $e_{16}$ sensiblement égale à $0{,}1{.}e_{13}$ et $0{,}9{.}e_{13}$.

Le procédé de fabrication est maintenant décrit selon un exemple particulier de réalisation en référence aux figures 15A à 15D. Comme illustré par les figures 15A et 15B, un empilement 18 destiné à former la structure III-V 12 peut-être fabriqué sur un substrat support 17 par croissance épitaxiale. Le procédé peut comprendre des étapes de dimensionnement pour déterminer l'épaisseur des couches de la structure III-V a formé, selon les modalités décrites précédemment. On comprend donc que les étapes de croissance épitaxiale peuvent donc être configurées pour obtenir les épaisseurs déterminées.

Le procédé peut ensuite comprendre au moins une étape de gravure de l'empilement 18 pour obtenir la structure III-V 12. Lors de cette ou ces gravure(s), la deuxième couche 15 et la couche active 14 sont gravées pour former le barreau III-V de largeur $L_{15}$. Plusieurs étapes de gravure peuvent être réalisées de sorte que la couche active présente un débord.

Le procédé peut ensuite comprendre un report de la structure III-V 12 sur le substrat 10 comprenant le guide d'onde Si 11, comme l'illustre la figure 15D. Le substrat 10 peut comprendre une portion supérieure 100 à base, ou constituée, de SiO$_2$. Le substrat 10 peut comprendre une portion inférieure 101 à base, ou constituée, de silicium. Le procédé peut prévoir des étapes dites « en face arrière » pour l'intégration de fonctionnalités ou de composants sur la portion inférieure 101 du substrat 10. Ces étapes ont lieu de préférence préalablement au report.

Pour cela, la fabrication de la partie substrat 10 peut être réalisée en amont. L'ensemble de ces étapes peut être réalisé en amont. Ces étapes peuvent par exemple inclure la réalisation des niveaux de métaux au-dessus du ou des guide(s) d'onde Si, et notamment pour connecter électriquement le ou les dispositifs optoélectroniques tels que les modulateurs ou les photodétecteurs. Ainsi, les guides d'onde Si 11 peuvent ne plus être accessibles par la face avant (supérieure) du substrat 10. Donc, au lieu de reporter la structure III-V 12 sur la surface supérieure du substrat 10 (tel qu'on le voit sur la figure 2A par exemple), la face avant du substrat 10 comprenant le guide d'onde Si 11 peut être collée sur un substrat support (typiquement à base de silicium) permettant la manipulation du substrat 10. Le substrat 10 peut être en partie gravé, permettant ainsi d'accéder à l'arrière du guide d'onde Si et d'intégrer la structure III-V couplée au guide d'onde silicium, comme l'illustre par exemple la figure 15D. L'avantage principal de cette approche est de permettre la réalisation d'une technologie photonique complète (incluant entre autres les routages électriques), tout en étant compatible avec l'intégration de composants III-V (via la face arrière).

L'invention n'est pas limitée aux modes de réalisations précédemment décrits et s'étend à tous les modes de réalisation couverts par l'invention. La présente invention ne se limite pas aux exemples précédemment décrits. Bien d'autres variantes de réalisation sont possibles, par exemple par combinaison de caractéristiques précédemment décrites, sans sortir du cadre de l'invention. Par exemple, dans la description qui précède, des exemples de structure III-V InP sont décrits. D'autres matériaux III-V peuvent être envisagés, et notamment des structures non pas basées sur de l'InP mais sur de l'AsGa et exploitant des alliages tels que l'AlGaAs ou l'InGaAs. En outre, les caractéristiques décrites relativement à un aspect de l'invention peuvent être combinées à un autre aspect de l'invention.

## Revendications

1. Dispositif optoélectronique (1) comprenant :

   • un substrat (10) comprenant un guide d'onde (11) à base de silicium présentant un indice de réfraction effectif,
   • une structure optiquement active à base d'au moins un matériau III-V, dite « structure III-V » (12), disposée sur le substrat (10), la structure III-V (12) comprenant :

     ◦ une première couche (13) présentant une première conductivité d'un premier type de porteur de charge,
     ◦ une couche active (14) configurée pour émettre ou recevoir un rayonnement lumineux, et surmontant la première couche (13),

◦ une deuxième couche (15) présentant un deuxième type de porteurs de charge, et surmontant la couche active (14), la première couche (13), la couche active (14) et la deuxième couche (15) étant configurées ensemble pour former un premier guide d'onde présentant un indice de réfraction effectif,

le dispositif optoélectronique (1) étant **caractérisé en ce que** la structure III-V (12) comprend en outre une couche intermédiaire (16) à base d'un matériau III-V configurée pour former un guide d'onde intermédiaire d'indice de réfraction effectif compris entre l'indice de réfraction effectif du premier guide d'onde et l'indice de réfraction effectif du guide d'onde à base de silicium (11), la couche intermédiaire (16) étant disposée entre la couche active (14) et le guide d'onde à base de silicium (11), de façon à obtenir un couplage optique entre le premier guide d'onde (12) et le guide d'onde intermédiaire (16), et un couplage optique entre le guide d'onde intermédiaire (16) et le guide d'onde à base de silicium (11).

2. Dispositif optoélectronique (1) selon la revendication précédente, dans lequel la deuxième couche (15) s'étend dans un plan d'extension principale (x,y) et présente au moins une dimension ($L_{15}$) dans ledit plan supérieure ou égale à 500 nm, de préférence comprise entre 700 nm et 20 $\mu$m.

3. Dispositif optoélectronique (1) selon l'une quelconque des revendications précédentes, dans lequel la couche intermédiaire (16) est à base d'un matériau présentant un indice de réfraction compris entre 3,2 et 3,5.

4. Dispositif optoélectronique (1) selon l'une quelconque des revendications précédentes, dans lequel la couche intermédiaire (16) présente une épaisseur $e_{16}$ comprise entre 100 nm et 250 nm.

5. Dispositif optoélectronique (1) selon l'une quelconque des revendications précédentes, dans lequel la couche intermédiaire (16) est à base d'In-GaAsP.

6. Dispositif optoélectronique (1) selon la revendication précédente, dans lequel l'InGaAsP est de formule $In_{1-x}Ga_xAs_yP_{1-y}$ avec x compris entre 0,1 et 0,4, de préférence sensiblement égal à 0,4, et y compris entre 0,1 et 0,8, de préférence sensiblement égal à 0,8.

7. Dispositif optoélectronique (1) selon l'une quelconque des revendications précédentes, dans lequel la première couche (13) comprend une première sous-couche (130) et une deuxième sous-couche (131) surmontant la première sous-couche (130), la couche intermédiaire (16) étant intercalée entre les première (130) et deuxième (131) sous-couches.

8. Dispositif optoélectronique (1) selon la revendication précédente, dans lequel la première sous-couche (130) présente une épaisseur $e_{130}$ la deuxième sous-couche (131) présente une épaisseur $e_{131}$, $e_{131}$ étant strictement supérieure à $e_{130}$.

9. Dispositif optoélectronique (1) selon l'une quelconque des revendications précédentes, dans lequel, entre une première interface (13a) entre la couche active (14) et la première couche (13) et une deuxième interface (13b) entre la première couche (13) et le substrat (10), la première couche (13) présente une épaisseur $e_{13}$ comprise entre 500 nm et 1500 nm.

10. Dispositif optoélectronique (1) selon l'une quelconque des revendications précédentes, dans lequel :

• une première portion (16a) de la couche intermédiaire (16) est au moins en partie superposée avec une portion (14a) de la couche active (14) au niveau d'une première zone de transition optique (1a), la première portion (16a) de la couche intermédiaire (16) et la portion (14a) de la couche active (14) présentant chacune une largeur $L_{16}$, $L_{14}$, dans leur plan d'extension principale, décroissante le long de la première zone de transition optique (1a), selon une direction de couplage (A) parallèle ou confondue avec la direction d'extension principale du guide d'onde à base de silicium (11) en s'éloignant de la structure III-V (12), la première zone de transition optique (1a) présentant une longueur L1 supérieure ou égale à 100 $\mu$m selon la direction de couplage (A),

• une deuxième portion (16b) de la couche intermédiaire (16) est au moins en partie superposée avec une portion (11b) du guide d'onde à base de silicium (11) au niveau d'une deuxième zone de transition optique (1b), la deuxième portion (16b) de la couche intermédiaire (16) et la portion (11b) du guide d'onde à base de silicium (11) présentant chacune une largeur $L_{16}$, $L_{11}$, dans leur plan d'extension principale, de sorte que :

◦ la largeur $L_{16}$ de la deuxième portion (16b) de la couche intermédiaire (16) est décroissante, et
◦ la largeur $L_{11}$ de la portion (11b) du guide d'onde à base de silicium (11) est croissante,

le long de la deuxième zone de transition optique (1b) en s'éloignant de la structure III-V (12) selon la direction de couplage (A), la deuxième zone de transition optique (1b) présentant une longueur L2 supérieure ou égale à 100 $\mu$m selon la direction de couplage (A).

11. Dispositif optoélectronique (1) selon l'une quelconque des revendications précédentes, dans lequel le dispositif (1) est un laser, un amplificateur optique ou un modulateur optique ou un photodétecteur.

12. Dispositif optoélectronique (1) selon l'une quelconque des revendications précédentes, configuré pour émettre ou recevoir un rayonnement dans le domaine lumineux de l'infra-rouge, et par exemple de longueur d'onde comprise entre 800 nm et 2 $\mu$m.

13. Procédé de fabrication d'un dispositif optoélectronique (1) selon l'une quelconque des revendications précédentes, le procédé comprenant :

    • une fourniture de la structure III-V (12),
    • une intégration par report de la structure III-V (12) sur le substrat (10) comprenant le guide d'onde à base de silicium (11).

14. Procédé de fabrication selon la revendication précédente, comprenant en outre un dimensionnement de la couche intermédiaire (16) comprenant :

    • une détermination d'une dimension $L_{15}$ de la deuxième couche (15) dans son plan d'extension principale (x,y), ladite dimension étant supérieure ou égale à 500 nm, de préférence comprise entre 700 nm et 20 $\mu$m,
    • la couche intermédiaire (16) présentant une épaisseur $e_{16}$, une détermination de l'épaisseur $e_{16}$ en fonction de la dimension $L_{15}$ de la deuxième couche (15) dans son plan d'extension principale,

et dans lequel la fourniture de la structure III-V (12) comprend :

    • une croissance épitaxiale de la couche intermédiaire (16) de sorte que la couche intermédiaire (16) présente l'épaisseur $e_{16}$ déterminée.
    • une gravure de la deuxième couche (15) de sorte que la deuxième couche (15) présente la dimension $L_{15}$ déterminée.

15. Procédé de fabrication selon l'une quelconque des deux revendications précédentes, comprenant en outre un dimensionnement de la première couche (13) comprenant :

    • une détermination d'une épaisseur $e_{13}$ de la première couche (13), prise entre une première interface (13a) entre la couche active (14) et la première couche (13) et une deuxième interface (13b) entre la première couche (13) et le substrat (10), permettant le transfert d'au moins 90 % de la lumière entre le guide d'onde actif et le guide d'onde intermédiaire (16) et entre le guide d'onde intermédiaire (16) et le guide d'onde à base de silicium (11),

et dans lequel la fourniture de la structure III-V (12) comprend :

    • une croissance épitaxiale de la première couche (13) de sorte que, après report, la couche active (14) et le substrat (10) soient séparés de l'épaisseur $e_{13}$ déterminée.

$n_{eff}(15')$

$\Delta n_{eff}$ (Si500)

$\Delta n_{eff}$ (Si300)

$L_{15'}$ (nm)

FIG. 1

15'
14' } 12'
13'
11'
10'

z
y $\otimes$ → x

FIG. 2A

15'
14' } 12'
13'
10'

$e_{11'}$

11'

z
x $\odot$ → y

FIG. 2B

FIG. 3

FIG. 4A

FIG. 4B

FIG. 5A

FIG. 5B

FIG. 6

FIG. 7

FIG. 8

**EP 4 764 632 A1**

FIG. 9A

FIG. 9B

FIG. 10

20

FIG. 11A

FIG. 11B

FIG. 12A

FIG. 12B

FIG. 13A

FIG. 13B

FIG. 13C

$L_{15}$

12

$L_1$, 1a

x

y      z

16      14      15

$L_{15}$

FIG. 14A

12

z

x      y

15

14

131

$e_{13}$

16      13

130

FIG. 14B

12

z

x      y

15

14

131

16      13

130

FIG. 14C

FIG. 15A

FIG. 15B

FIG. 15C

FIG. 15D

**Europäisches Patentamt**
**European Patent Office**
**Office européen des brevets**

## RAPPORT DE RECHERCHE EUROPEENNE

**Numéro de la demande**

**EP 25 22 3659**

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2024/061176 A1 (BIAN YUSHENG [US]) 22 février 2024 (2024-02-22) * alinéas [0027] - [0041] * * figures 3, 6 * ----- | 1-15 | INV. G02B6/12 ADD. G02B6/122 |
| X | US 2022/255297 A1 (GARDES FREDERIC [GB] ET AL) 11 août 2022 (2022-08-11) * alinéas [0008] - [0085] * * figures 1, 3 * ----- | 1-15 | |
| A | US 2022/003929 A1 (KOCH BRIAN [US] ET AL) 6 janvier 2022 (2022-01-06) * alinéas [0087], [0088] * * figure 1 * ----- | 1-15 | |
| A | EP 4 163 684 A1 (COMMISSARIAT ENERGIE ATOMIQUE [FR]) 12 avril 2023 (2023-04-12) * alinéas [0046] - [0048] * ----- | 1-15 | |

**DOMAINES TECHNIQUES RECHERCHES (IPC)**

G02B

Le présent rapport a été établi pour toutes les revendications

| Lieu de la recherche | Date d'achèvement de la recherche | Examinateur |
|---|---|---|
| La Haye | 10 avril 2026 | Hohmann, Leander |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
......................................................................................
& : membre de la même famille, document correspondant

EPO FORM 1503 03.82 (P04C02)

**EP 4 764 632 A1**

## ANNEXE AU RAPPORT DE RECHERCHE EUROPEENNE
## RELATIF A LA DEMANDE DE BREVET EUROPEEN NO.

EP 25 22 3659

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-04-2026

| Document brevet cité au rapport de recherche | Date de publication | Membre(s) de la famille de brevet(s) | Date de publication |
|---|---|---|---|
| US 2024061176 A1 | 22-02-2024 | AUCUN | |
| US 2022255297 A1 | 11-08-2022 | EP 4004989 A1 | 01-06-2022 |
| | | GB 2586444 A | 24-02-2021 |
| | | US 2022255297 A1 | 11-08-2022 |
| | | WO 2021018832 A1 | 04-02-2021 |
| US 2022003929 A1 | 06-01-2022 | US 2021215874 A1 | 15-07-2021 |
| | | US 2021215875 A1 | 15-07-2021 |
| | | US 2022003929 A1 | 06-01-2022 |
| EP 4163684 A1 | 12-04-2023 | EP 4163684 A1 | 12-04-2023 |
| | | FR 3127825 A1 | 07-04-2023 |
| | | US 2023105346 A1 | 06-04-2023 |

EPO FORM P0460

Pour tout renseignement concernant cette annexe : voir Journal Officiel de l'Office européen des brevets, No.12/82

## EP 4 764 632 A1

**Documents brevets cités dans la description**

- US 2024061176 A1

- US 2022255297 A1

**Littérature non-brevet citée dans la description**

- **DUAN, G. H. et al.** Hybrid III--V on Silicon Lasers for Photonic Integrated Circuits on Silicon.. *IEEE Journal of selected topics in quantum electronics*, 2014, vol. 20 (4), 158-120